Europäisches Patentamt

European Patent Office

Office européen des brevets

(11) Publication number: **0 501 216 A1**

# EUROPEAN PATENT APPLICATION

(21) Application number: **92102204.2**

(22) Date of filing: **10.02.92**

(51) Int. Cl.⁵: **G03B 27/32**, G03F 7/00

(30) Priority: **19.02.91 JP 24930/91**
**19.02.91 JP 24932/91**
**10.09.91 JP 230444/91**

(43) Date of publication of application:
**02.09.92 Bulletin 92/36**

(84) Designated Contracting States:
**DE FR GB**

(71) Applicant: **SEIKO EPSON CORPORATION**
**4-1, Nishishinjuku 2-chome**
**Shinjuku-ku Tokyo-to(JP)**
Applicant: **SEIKO INSTRUMENTS INC.**
**31-1, Kameido 6-chome Koto-ku**
**Tokyo 136(JP)**

(72) Inventor: **Kobayashi, Atsushi, c/o Seiko Epson**
**Corporation**
**3-5, Owa 3-chome**
**Suwa-shi, Nagano-ken(JP)**
Inventor: **Abe, Nobumasa, c/o Seiko Epson**
**Corporation**
**3-5, Owa 3-chome**
**Suwa-shi, Nagano-ken(JP)**

(74) Representative: **Blumbach Weser Bergen**
**Kramer Zwirner Hoffmann Patentanwälte**
**Radeckestrasse 43**
**W-8000 München 60(DE)**

(54) **Image forming device.**

㊼ Disclosed is an image forming device in which a long photosensitive member (F) is sequentially transported from a supply section (5) along a transport path (6) to an exposure section (4), a heat developing section (7) and a pressure transfer section (8), a latent image is formed on the photosensitive member by exposure to an input image in the exposure section (4), the latent image is heat developed in the heat developing section (7) and the developed image is then transferred to a transfer member (P) in the pressure transfer section (8). In order to maintain the transport speed of the photosensitive member (F) constant in the exposure section (4), to prevent the transport speed downstream from the exposure section (4) from affecting the transport speed in the exposure section (4), and to absorb slack in the photosensitive member (F), a main transport means (72, 76, 103) for transporting the photosensitive member along the transport path (6) is disposed in the pressure transfer section (8). This facilitates achieving an accurate, smooth transport of the photosensitive member F with a simple configuration.

EP 0 501 216 A1

FIG. 2

The present invention relates to image forming devices such as copiers, printers, plotters, facsimile machines and other image forming devices that form images by means of a photosensitive transfer type heat developing member, and more particularly to the means for transporting the photosensitive member in such devices.

An image forming device of this type is disclosed in JP-A-62-147461. This prior art device is a color copier comprising a photosensitive member supply section, an exposure section, a heat developing section, a pressure transfer section and a photosensitive member collection section which are provided along a transport path. The photosensitive member supply section houses a film type photosensitive member rolled up on a core (roll), and it is configured such that it is capable of cutting the photosensitive member to the prescribed length and then supplying it to the exposure section. The exposure section receives light reflected by an original and exposes the photosensitive surface of the photosensitive member to form a latent image corresponding to the original. The heat developing section heat develops the latent image formed on the photosensitive member by heating the photosensitive member to 80° to 200°C for approximately 30 s. The pressure transfer section mates the photosensitive member with a transfer member made from paper, etc., transfers the image on the developed photosensitive member to the transfer member using pressure, and then separates the photosensitive member and the transfer member. In the photosensitive member collection section, the photosensitive member from which the image has been transferred is successively ejected and stacked.

In this prior art the photosensitive member is transported to each section after it has been cut and, therefore, the transport system comprises drive rollers in the photosensitive member supply section, exposure section, heat developing section, pressure transfer section and photosensitive member collection section in order to transport the photosensitive member in each section.

A drive roller includes a motor or speed reducer as the drive source and a control device and, therefore, the structure and control of a transport system according to this prior art are extremely complicated. To overcome these problems, a roll type photosensitive member can be used which is continuously transported in its original uncut form. However, in this case the following problems occur:

(1) It is necessary to keep the transport speed of the photosensitive member constant in the exposure section. That is, since the photosensitive member is image exposed by the original by a scanning type exposure, the latent image will become distorted if the transport speed of the photosensitive member, which determines the scanning speed in one of the two scanning directions, changes.

(2) When a drive roller is provided in the vicinity of the exposure section that is supposed to keep the transport speed constant in the exposure section, and is linked to a drive roller in the pressure transfer section located farthest downstream, the transport speed of the photosensitive member in the exposure section will differ from that in the pressure transfer section due to a stretching of shrinkage of the photosensitive member in the heat developing section, an expansion or contraction of the drive roller itself in the pressure transfer section or a transfer in a pressurized condition. Therefore, a strong tension condition will occur in the photosensitive member between the exposure section and the pressure transfer section, thus resulting in a slack, etc. A slack condition may cause uneven developing or jamming of the photosensitive member. Therefore, it is necessary to eliminate slack in the photosensitive member in addition to using a slower transport speed in the pressure transfer section than in the exposure section.

The present invention is intended to solve the above problems and its purpose is to provide an image forming device with a simple configuration that is capable of maintaining the transport speed of the photosensitive member constant in the exposure section and smoothly transporting the photosensitive member from the exposure section to the pressure transfer section.

This object is achieved with an image forming device as claimed in claim 1.

Specific embodiments of the invention are subject of the dependent claims.

Since, according to the invention, a main transport means for transporting the photosensitive member is disposed in the pressure transfer section located farthest downstream in the transport path, transport of the entire photosensitive member in this section can be performed in one operation, thus eliminating the need for transport means in other sections. If a speed sensor is disposed in the transport path upstream from the heat developing section, i.e. in the exposure section or before or after the exposure section, and the transport speed of the main transport means is controlled based on the value detected by the speed sensor, the transport speed of the photosensitive member in the exposure section can be continually regulated to a desired speed without slack forming in the photosensitive member.

By disposing a speed sensor upstream from the heat developing section together with a secondary transport means between the heat developing section and the pressure transfer section or in the heat developing section, the transport speed of the photosensitive member in the exposure section can be continually regulated to the desired speed, and the transport zones of the main transport means and the secondary transport means can be separated, thus eliminating any effect on the upstream side of the main transport means, which includes the exposure section.

By disposing a secondary transport means between the exposure section and the heat developing section or between the supply section and the exposure section, the transport speed of the photosensitive member in the exposure section can be maintained continually constant without requiring a speed sensor or other detection means.

By disposing a speed sensor upstream from the heat developing section in addition to a secondary transport means in the supply section and controlling the secondary transport means based on the output of this speed sensor the transport speed of the photosensitive member in the exposure section can be continually regulated to the desired speed, and rewinding or recollecting of the photosensitive member is facilitated by rotating the secondary transport means in reverse.

Further, by appropriately disposing a tensioning means downstream from the secondary transport means, the photosensitive member can be transported between the secondary transport means and the main transport means in a tensioned condition, thus preventing wrinkles, snaking or jamming due to slack in this part.

The invention thus provides an image forming device whose transport system can be configured extremely simply. When the transport system is divided up into secondary transport means for the first part and main transport means for the latter part and mutual interference between these transport means is eliminated, the transport speed can be maintained constant in the exposure section and smooth transport can be facilitated by absorbing changes in transport speed from the heat developing section to the pressure transfer section. Snaking or jamming of the photosensitive member caused by separating the transport system into those two parts can be prevented by employing a tensioning means that applies a tension to the photosensitive member, thus ensuring a smoother transport. Moreover, by applying a tension to the photosensitive member, wrinkles can be prevented to further improve the image quality.

Embodiments of the invention will be explained in more detail below with reference to the drawings, in which:

Fig. 1     is a cutaway view of a color copier embodying the invention,

Fig. 2     is a cutaway view of a color copier showing a first embodiment of the transport system,

Fig. 3     is a cutaway view of a color copier showing a second embodiment of the transport system,

Fig. 4     is a cutaway view of a color copier showing a third embodiment of the transport system,

Fig. 5     is a cutaway view of a color copier showing a fourth embodiment of the transport system,

Fig. 6     is a cutaway view of a color copier showing a fifth embodiment of the transport system,

Fig. 7     is a cutaway view of a color copier showing a sixth embodiment of the transport system,

Fig. 8     is a perspective view of a sensor means disposed before or after the exposure section, and

Fig. 9     is a perspective view of a sensor means disposed inside the exposure section.

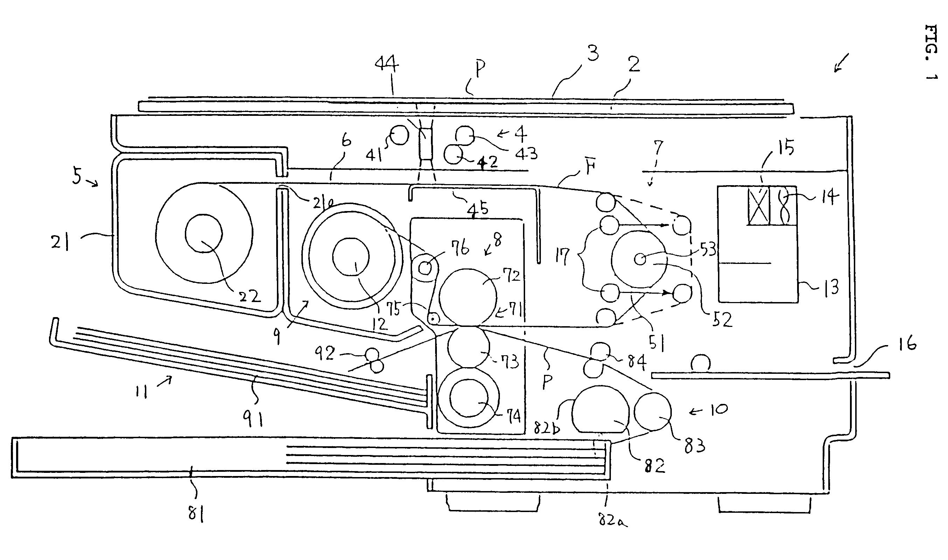

Fig. 1 is a cutaway side view of a color copier employing an embodiment of the invention. As shown in the Figure, the top surface of a copier main unit 1 is a glass original table 2, and above that an original table cover 3 is attached in such a way that it can be moved between a closed position as shown and an upright opened position. An original A used as the input image is set on the original table 2, and it is copied while being held down by the original table cover 3.

An exposure section 4 is positioned inside the main unit 1 below the original table 2, and a supply section 5, which supplies the photosensitive member F, is positioned upstream from the exposure section 4. The supply section 5 is a magazine type unit that houses the photosensitive member F, and it is configured such that it can be freely attached to and detached from the main unit 1. The photosensitive member F supplied from the supply section 5 to the main unit 1 is transported along a transport path 6 as required and sequentially faces the exposure section 4, a heat developing section 7, a pressure transfer section 8 and a photosensitive member collection section 9. The transport path 6 turns back in the heat developing section 7, and each section is efficiently positioned in the main unit 1 to keep the main unit compact.

A latent image is formed on the photosensitive member F, which is transported from the supply section 5 along the transport path 6, by exposure to the input image in the exposure section 4, after which the latent image is heat developed by heating it to approximately 150°C in the heat developing section 7. The photosensitive member F, which has undergone developing, is then aligned with a paper P as the transfer member, in the pressure transfer section 8, and the developed image is pressure transferred to the paper P. Finally, the photosensitive member F and paper P are separated and the photosensitive member F is collected by rolling it up in the photosensitive member collection section 9. The paper P is supplied to the pressure transfer section 8 from a paper supply section 10 at the bottom of the main unit 1, and paper P onto which the output image has been transferred is discharged to the paper outlet section 11.

The photosensitive member F is comprised of a polyethylene terephthalate (PET) film as a base material and microcapsules charged with a coloring material and a photosensitive substance, which is made up of a photosensitive silver halide, a reducing agent and a polymer compound, and applied to the surface of the base material. The photosensitive substance performs a trigger-like function in that it undergoes a photoreaction that results in hardening of the coloring material during the development. The coloring material is provided in the colors yellow, magenta and cyan, and microcapsules of these three colors in which these coloring materials are charged are abundantly applied to the surface of the PET film in a mixed condition.

In the image forming process in this embodiment the photosensitive material F undergoes a photoreaction in the exposure section 4 (formation of latent image), and the resulting change of state affects the coloring material when heated in the heat developing section 7 so that it is selectively hardened (developing). The microcapsules are crushed in the pressure transfer section 8, whereby the coloring material that has not hardened is transferred to the paper P to form the output image.

The left side of the main unit 1 shown in Fig. 1 is the supply section 5. It comprises a black box magazine 21 housing the photosensitive member, which can be attached to or detached from the main unit 1 by suitable means not shown. By means of this attachment and detachment, unexposed photosensitive member F can be mounted and exposed photosensitive member F can be rewound into the magazine 21 and discarded. The photosensitive member F is formed as one long piece and is rolled up on the supply roller 22 housed in the magazine 21. The photosensitive member F is continuously unrolled from the supply roller 22 with its photosensitive side facing upward and supplied through a slit 21a in the magazine 21 to the exposure section 4 located downstream.

The exposure section 4 comprises R, G and B lamps i.e., a red lamp 41, a green lamp 42 and a blue lamp 43, as light sources, a converging lens 44 and an exposure table 45, and the photosensitive member F travels on top of the exposure table 45. The red lamp 41, green lamp 42 and blue lamp 43 irradiate light toward the original on the original table 2 by means of a reflector (not shown), and the light reflected by the original A is projected on the photosensitive surface of the photosensitive member F by the converging lens 44 and a shutter (not shown), whereby exposure of the photosensitive member F is performed. In this case, the original A moves forward and backward together with the original table 2, and the photosensitive member F is transported at the same speed, thus implementing a so-called "scan exposure system".

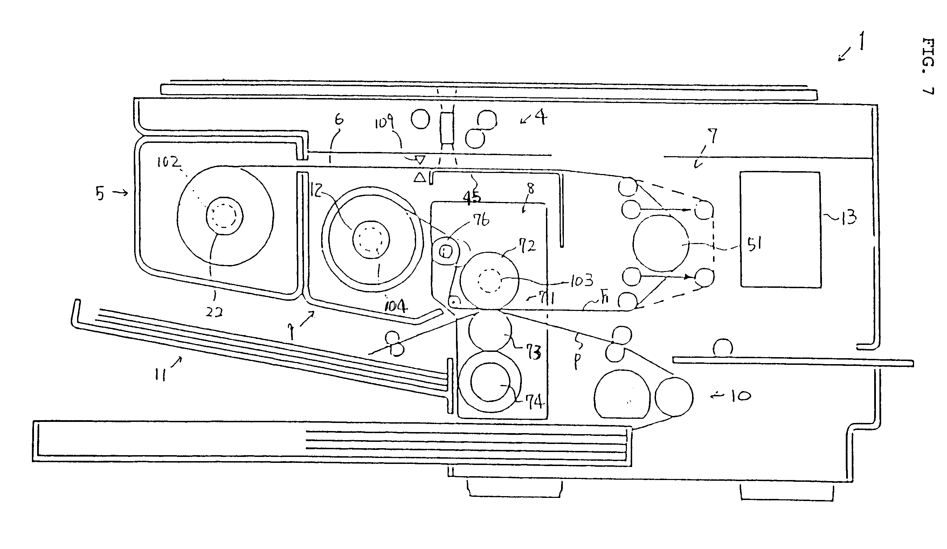

The heat developing section 7 is provided with a heating roller means 51, which serves as the heating member, and comprises a main roller unit 52 (Fig. 7) supported on a frame (not shown) of the main unit 1 so that it can rotate freely, and a halogen lamp heater 53 mounted inside the main roller unit 52. The surface temperature of the main roller unit 52 is controlled by switching this halogen lamp heater 53 on and off so that the temperature is 150 ± 3°C (155°C in some cases), and the rear surface of the photosensitive member F comes into direct contact with the surface of the main roller unit 52. The photosensitive member F is wound around the main roller unit 52 at a prescribed angle, it is heated at a prescribed developing temperature for a prescribed time period, and then it makes a U turn back toward the pressure transfer section 8. In this case, instead of a halogen lamp heater, an infrared heater, a rod-shaped ceramic heater, a sheet-shaped heating element, an electrode induction heating, electromagnetic wave heating or other type heating can be employed.

The pressure transfer section 8 comprises a transfer roller means 71, which is made up of a top roller 72, a middle roller 73 and a bottom roller 74, to which are added a separation roller 75 and a pinch roller 76. The photosensitive member F and the paper P are inserted together between the top and middle rollers 72 and 73, and here the image on the developed photosensitive member F is transferred to the paper P. In this case, it is desirable that the transfer temperature be 70 ± 3°C, the speed at which the photosensitive member F heated in the heat developing section 7 is transported is controlled so that it has cooled to this temperature by the time it reaches this section. The top roller 72 and middle roller 73 are made from metal or another hard material, and using the top roller 72 as the drive roller, transfer is performed by forcefully pressing the photosensitive member F and paper P between both rollers 72 and 73. As explained before this transfer is performed by crushing the microcapsules on the photosensitive member F, and therefore it is necessary to apply a strong, uniform pressure to the photosensitive member F and paper P. Here, the bottom roller 74 is in contact with the middle roller 73 so that a uniform pressure can be applied to the middle roller 73. Further, when transfer is not being performed, the middle and bottom rollers 73 and 74 move down to terminate the transfer condition. The separation roller 75 is positioned near the downstream side of the transfer roller means 71, and here the photosensitive member F and paper P are forcefully separated by bending the transport path of the photosensitive member F sharply to the inside. When the photosensitive member F is transported, the pinch roller 76 is moved to the position indicated by the dotted lines in the Figure so as to sandwich the photosensitive member F between it and the top roller 72 and apply a transport force to the photosensitive member F. That is, the pinch roller 76 is a free roller, and when it falls against the top roller 72, which is the drive roller, the photosensitive member F receives the transport force. The separated photosensitive member F is carried to the photosensitive member collection section 9 by the pinch roller 76. Desirable relationships of the transfer pressure to the transfer temperature are as follows: 100 N/mm$^2$ (1000 kg/cm$^2$) at 20°C, 40 N/mm$^2$ (400 kg/cm$^2$) at 50°C, 20 N/mm$^2$ (200 kg/cm$^2$) at 70°C and 10 N/mm$^2$ (100 kg/cm$^2$) at 90°C.

The photosensitive member collection section 9 has a take-up roller 12 on which used photosensitive member F is rolled up in a roll. When all of the photosensitive member F has been rolled up on the take-up roller 12, a clutch is disengaged to allow take-up roller 12 to rotate freely. In this condition, the supply roller 22 of the supply section 5 is driven in the opposite direction, and ultimately the used photosensitive member F is recollected in the magazine 21.

The paper supply section 10 comprises a paper cassette 81, which supplies the paper P as cut sheet paper, a half-moon roller 82, which feeds out the paper from the paper cassette 81 one sheet at a time, a guide roller 83, which changes the path that the paper P follows, and a paper supply roller means 84, which guides the paper P that has been fed out to the pressure transfer section 8. The paper cassette 81 is configured such that it can be freely attached to and detached from the main unit 1, and multiple cassettes are provided to accommodate various sizes of paper. The half-moon roller 82 has a rubber surface around its perimeter which comprises a straight part 82a and a curved part 82b. The transition part between the straight part 82a and the curved part 82b catches the leading edge of the paper P, and the following curved part 82b feeds the paper P until its leading edge reaches the paper supply roller means 84. Supply of the paper P is initiated in synchronism with the transport of the photosensitive member F so that the paper P is aligned with the exposed part of the photosensitive member F.

The paper outlet section 11 comprises an ejected paper cassette 91, which holds the paper P to which an image has been transferred, and a paper eject roller means 92, which guides the paper P from the transfer section 8 to this paper cassette 91. The paper eject roller means 92 is configured such that it tends to feed slightly faster than the paper supply roller means 84, and the resulting slip rotation feeds out the paper P while also applying tension to the paper P so that it will not wrinkle or become jammed during pressure transfer.

In the Figure, 13 is an exhaust unit comprising a gas filter 15 built into an exhaust fan 14, and it exhausts heat and gas generated in the main unit 1 through the gas filter 15 to the outside. Also, in the Figure, 16 is a manual paper supply inlet for manually supplying paper P.

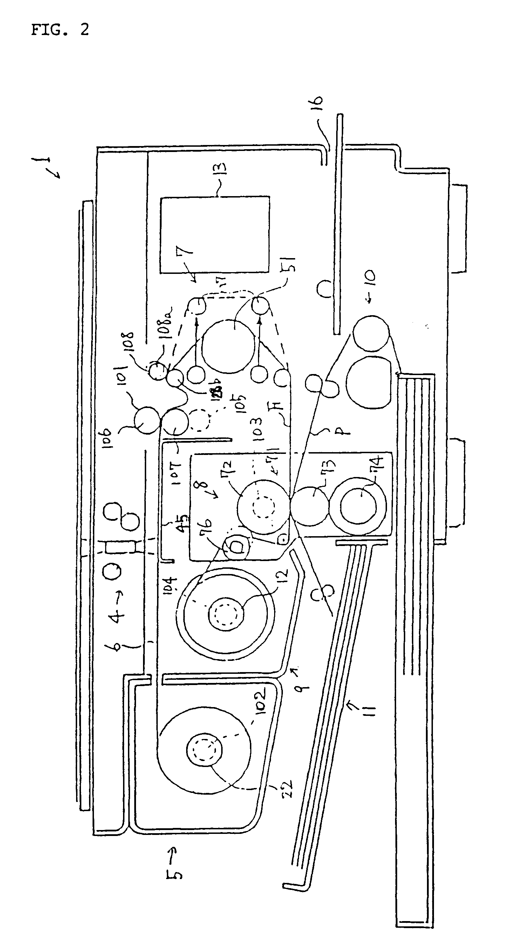

The copying process is not completed until the exposed part of the photosensitive member F reaches the pressure transfer section. There is no problem when copying is performed continuously, but in other cases, an unexposed part is sent to the pressure transfer section along with the exposed part. When the next exposure is performed in this condition, the unexposed part from the exposure section 4 to the pressure transfer section 8 is unnecessarily wasted. In this embodiment, the unexposed part is returned to near the exposure section in such cases. That is, a drive motor 102 (see Fig. 2) connected to the supply roller 22 of the supply section 5 reverses, whereby the photosensitive member F is re-wound until the boundary between the exposed part and the unexposed part reaches the vicinity of the exposure section 4.

Since in this way the unexposed part of the photosensitive member F is not wasted, it is necessary that this part is not developed in the heat developing section 7 when the unexposed part is fed forward behind the exposed part or pulled back. Therefore, contact between the heating roller means 51 and the photosensitive member F is broken at this time. That is, a pair of movable idle rollers 17 is positioned upstream and downstream from the heating roller means 51, and these rollers 17 move horizontally so that they pull on the photosensitive member F on the transport path 6 in two locations. This movement changes the transport path so that the photosensitive member F is separated from the heating roller means 51. Therefore, when exposure is not performed continuously, the idle rollers 17 are driven at the point when the exposed part passes by the heating roller means 51 and separate the photosensitive member F from the heating roller means 51, and this separated condition is maintained until rewinding is completed when the photosensitive member F is then rewound.

In the following the transport system for the photosensitive member in the above general embodiment will be explained in detail. The most important factors to consider in this transport system are

(1) the transport speed of the photosensitive member F has to be maintained constant in the exposure section 4,

(2) the transport speed downstream from the exposure section 4 has to be made slower than that in the exposure section 4 in order not to allow any shrinkage of the photosensitive member F or changes in the transport speed due to an expansion of rollers in the transfer roller means 71 or pressurizing transport, to effect the transport speed in the exposure section 4, and

(3) a slack in the photosensitive member F caused by (2) above somewhere in the transport path 6 must be absorbed. Below are explanations of several specific embodiments in which these factors are considered.

Fig. 2 shows the photosensitive member transport system of a first embodiment. As shown in this Fig., the transport system is made up of the supply roller 22 of the supply section 5, the top roller 72 (transfer roller means 71), which is the main transport means of the pressure transfer section 8, the take-up roller 12 of the photosensitive member collection section 9 and feed roller means 101 which a secondary transport means disposed in the transport path downstream from the exposure section 4. The supply roller 22 mainly performs feed out from the magazine 21 by the forward drive of the supply drive motor 102 connected to it, when the photosensitive member F is initially set. The supply roller 22 is further used for rewinding by reverse drive of the motor 102. This rewinding is performed to bring back the used photosensitive member F from the take-up roller 12 into the magazine 21 to facilitate disposal of the used photosensitive member F. Rewinding is also used to return an unexposed part of the photosensitive member F to the exposure section 4.

The top roller 72 positioned downstream from the feed roller means 101 transports the photosensitive member F by the drive of the transfer drive motor 103 connected to it. The top roller 72 transports the photosensitive member F in cooperation with the pinch roller 76 which is moved to the position indicated by the dashed line in the Figure. In this case, changes in the transport speed due to a shrinkage of the photosensitive member F in the heat developing section 7 and an expansion or contraction of the top roller 72 itself in the pressure transfer section are absorbed and, therefore, the top roller 72 is set to a transport speed slightly lower than that of the feed roller means 101. In this way, the top roller 72 and the feed roller means 101 can transport the photosensitive member F without interfering with each other and tearing of the photosensitive member F can be prevented since it is not subjected to any excessive tension.

The take-up roller 12 is driven by the take-up drive motor 104 and takes up the used photosensitive member F. The take-up drive motor 104 is a constant speed motor. In this case, since the photosensitive member F is taken up in a roll, it is necessary to change the take-up speed due to the changing roll diameter. To do this, a torque limiter is provided on the take-up roller 12 and changes in speed are absorbed by the slippage of the torque limiter.

The feed roller means 101 performs transport in the first part of the transport path 6 and is driven by a feed motor 105. This transport includes speed control of the photosensitive member F in the exposure section 4 and pulling the photosensitive member F from the supply section 5. The feed roller means 101 comprises a drive roller 106 to which the feed motor 105 is connected, and a pressure roller 107. The photosensitive member F passes between these two rollers pressed against each other, and a transport force is applied to the photosensitive member F by the squeezing action of these two rollers. The feed motor 105 is a constant speed motor driving the drive roller 106 at a constant speed so that the photosensitive member F travels at a constant speed over the exposure table 45. This constant speed travel facilitates an accurate exposure. In this case, as described above, the feed roller means 101 transports at a speed slightly faster than that of the transfer roller means 71 which results in a slack in the photosensitive member F between the feed roller means 101 and the transfer roller means 71. If this slack is small, no problem is caused, although it can cause snaking or jamming of the photosensitive member F if it becomes large. Therefore, in this embodiment, a tension roller means 108 is disposed as a tensioning means downstream from the feed roller means 101 between the exposure section 4 and the heat developing section 7.

The tension roller means 108 comprises a pair of upper and lower idle rollers 108a and 108b sandwiching the photosensitive member F between them, and a torque limiter (not shown) connected to the rotational or shaft of the idle roller 108a. A desired tension is applied to the photosensitive member F by adjusting the damping torque of the torque limiter. By this means, the photosensitive member F downstream from the tension roller means 108 and up to the pressure transfer section 8 is in a tensioned condition which prevents snaking or jams as well as wrinkles to be generated in the photosensitive member F in the heat developing section 7. Upstream from the tension roller means 108 a slack in the photosensitive member F results from the difference in the transport speeds of the feed roller means 101 and the transfer roller means 71, thus forming some kind of a "buffer". Since this buffer exists, the transfer roller means does not need to be driven in synchronism with the transport of the photosensitive member F in the exposure section 4. Even when the photosensitive member F in the exposure section 4 is stopped and started frequently the transfer roller means 71 and the heating roller means 51 can be driven continuously.

Below, the drive system, i.e. the series of actions of the transport system for the photosensitive member F is explained together with the transport system for the paper P. The feed roller means 101 is driven when the exposure starts and the photosensitive member F is pulled out from the magazine 21. The pinch roller 76 comes into contact with the top roller 72 and drive of the top roller 72 starts slightly delayed behind the start of the drive of the feed roller means 101. The take-up roller 12 is driven sequentially with the drive of the top roller 72. After passing the feed roller means 101, the exposed part of the photosensitive member F is transported by the top roller 72 to the pressure transfer section 8 from the tension roller means 108 and through the heat developing section 7. When the exposed part of the photosensitive member F is transported to near the pressure transfer section 8, the half-moon roller 82 is driven and feeds out the paper P, after which the paper supply roller means 84 is driven and aligns the paper P up with the exposed part of the photosensitive member F. When the transfer begins, the paper eject roller 92 is driven and carries the separated paper P to the ejected paper casette 91, while the photosensitive member F is rolled up on the take-up roller 12 after passing the pinch roller 76. In this case, the movable rollers 17 are driven when the unexposed part of the photosensitive member F reaches the heat developing section 7 and separate the photosensitive member F and the heating roller means 51 and, when the photosensitive member reaches the pressure transfer section 8, the middle and bottom rollers 73 and 74 move down and release the transfer condition. All of the rollers stop when one complete copy operation has been completed. As the rollers stop, the pinch roller 76 separates from the top roller 72, the bottom roller 74 moves down releasing the contact between the top roller 72 and the middle roller 73, and the movable rollers 17 are driven to release the contact between the photosensitive member F and the heating roller means 51. When rewinding is performed, the clutches of the feed roller means 101, pinch roller 76 and take-up roller 12 are switched to allow these rollers to turn freely, and the supply roller 22 is driven in reverse and rolls the photosensitive member F back up.

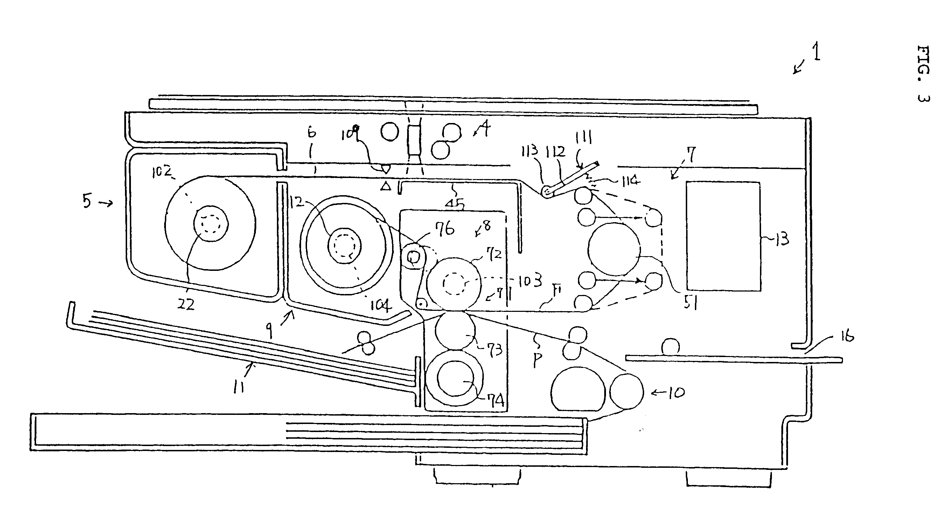

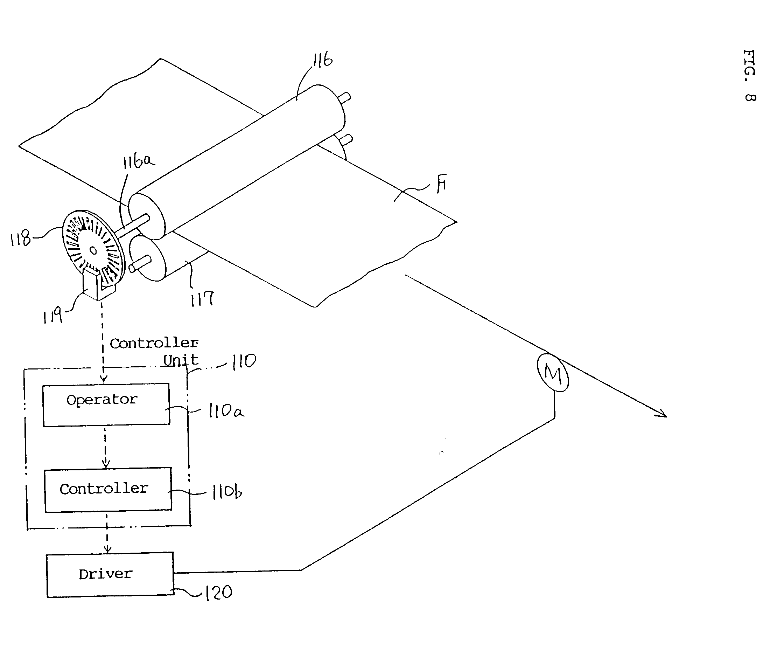

Fig. 3 shows the transport system for the photosensitive member F according to a second embodiment. In this embodiment, the transport system of the main unit 1 comprises the drive motors 102, 103 and 104 connected to the supply roller 22 of the supply section 5, the top roller 72 in the transfer roller means 71 of the pressure transfer section 8 and the take-up roller 12 of the photosensitive member collection section 9, respectively. In this case, the top roller 72 is the main transport means while the supply roller 22 is the secondary transport means. That is, the supply drive motor 102 for the supply roller 22 in the supply section 5 is a variable speed motor, the transport speed of the photosensitive member is detected by a sensor means 109 positioned upstream from the exposure table 45 of the exposure section 4, and the supply drive motor 102 is controlled by a controller 110 (see Fig. 8) based on the detected speed value, whereby the transport speed of the photosensitive member is maintained constant. The slack in the photosensitive member F caused by the difference in the transport speeds of the supply roller 22 and the top roller 72 is absorbed by a tension arm 111 disposed between the exposure section 4 and the heat developing section 7.

This tension arm 111 comprises a main arm unit 112 fixed to the frame (not shown) of the main unit 1 to be freely pivotable, a pressure roller 113 supported at the end of the main arm unit 112 to be freely rotatable, and a coil spring 114 that presses the main arm unit 112 against the photosensitive member F. The tension arm 111 comes into contact with the photosensitive side of the photosensitive member F which it gently pushes to the inside, i.e., a direction perpendicular to the direction of transport, to take up the slack in the photosensitive member. Therefore, the transport speed of the photosensitive member F travelling on the exposure table 45 of the exposure section 4 is maintained constant by the supply drive motor 102 while also forming a buffer in this part.

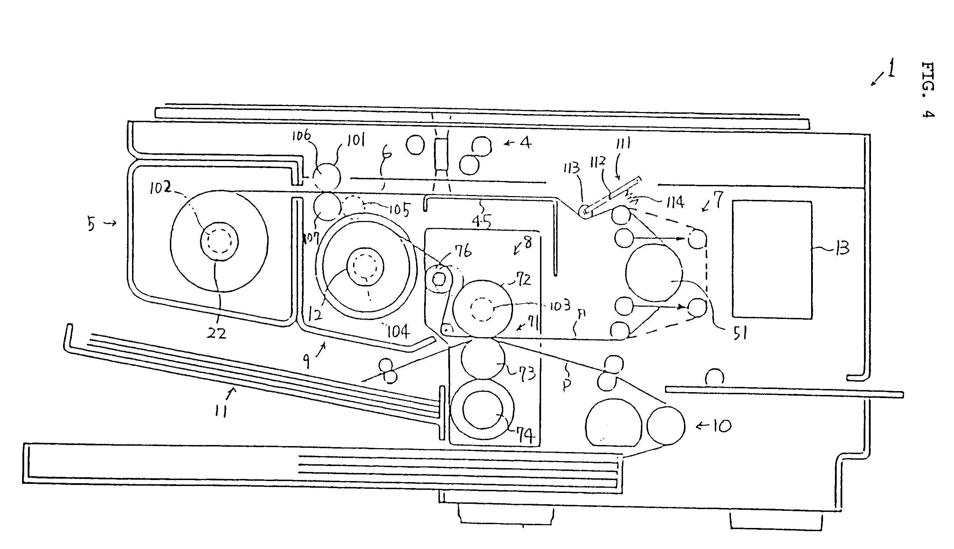

Fig. 4 shows the transport system for the photosensitive member F in a third embodiment. In this embodiment, the transport system of the main unit 1 comprises the drive motors 102, 103 and 104 connected to the supply roller 22 of the supply section 5, the top roller 72 (transfer roller means 71) of the pressure transfer section 8 and the take-up roller 12 of the photosensitive member collection section 9, respectively, and the feed roller means 101 disposed in the transport path 6 between the supply section 5 and the exposure section 4 as the secondary transport means. As in the first embodiment, the feed roller means is driven at a slightly faster speed than the top roller 72 which is the main transport means. The feed roller means 101 comprises the drive roller 106 to which the feed motor 105 is connected and the pressure roller 107, whereby the transport speed of the photosensitive member F in the exposure section 4 is maintained constant. Also, the tension arm 111 is disposed between the exposure section 4 and the heat developing section 7 as in the second embodiment, whereby a slack in the photosensitive member F can be absorbed. In this case, the transport speed can be maintained constant in the exposure section 4 without requiring sensors, etc.

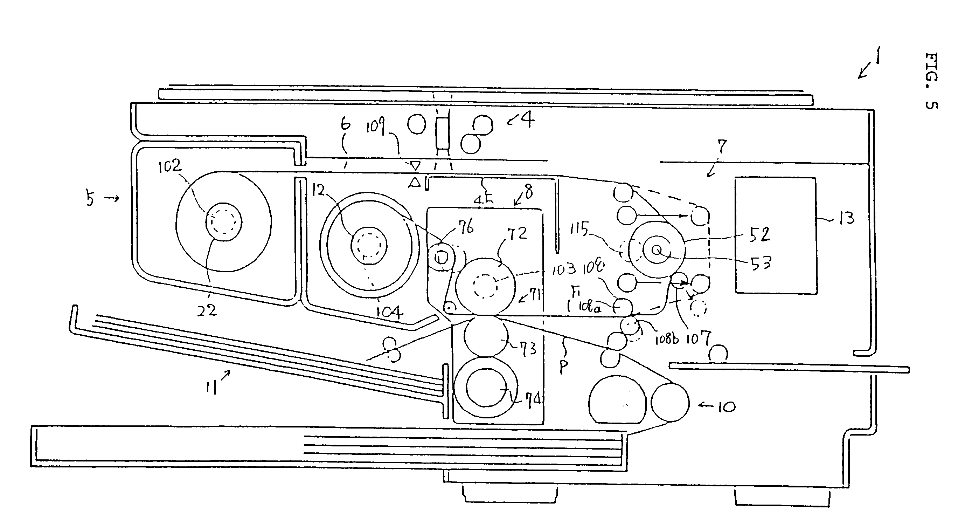

Fig. 5 shows the transport system for the photosensitive member F in a fourth embodiment. In this embodiment, the transport system of the main unit 1 comprises the drive motors 102, 103 and 104 connected to the supply roller 22 of the supply section 5, the top roller 72 (transfer roller means 71) of the pressure transfer section 8 and the take-up roller 12 of the photosensitive member collection section 9, respectively, and the driven heating roller 52 of the heat developing section 7. The heating drive motor 115 is connected to the heating roller 52, and a pressure roller 107 comes into contact with the heating roller 52 so that the photosensitive member is sandwiched between them, thus making up the secondary transport means in which the heating roller 52 and the pressure roller 107 apply transport force to the photosensitive member F. The heating drive motor 115 is a variable speed motor. The transport speed of the photosensitive member F in the exposure section 4 is detected by the sensor means 109 disposed upstream from the exposure section 4, and the rotational speed of the heating drive motor 115 is varied based on the detected speed. In this way, the rotational speed of the heating drive motor 115 is varied so that the speed of the photosensitive member F in the exposure section F is faster than in the pressure transfer section 8 and is maintained constant even though the photosensitive member F should shrink in the heat developing section 7. As in the first embodiment, a tension roller means 108 is disposed in the transport path 6 downstream from the heating roller 52, whereby the photosensitive member F is sent to the pressure transfer section 8 in a tensioned condition while a buffer is formed in this part.

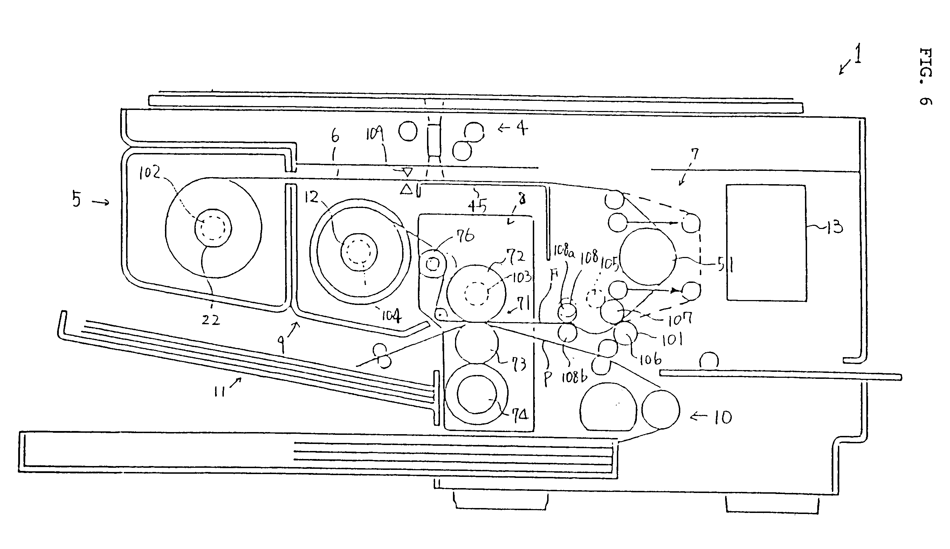

Fig. 6 shows the transport system for the photosensitive member F in a fifth embodiment. In this embodiment, as in the first embodiment, the transport system of the main unit 1 comprises the drive motors 102, 103, 104 and 105 connected to the supply roller 22 of the supply section 5, the top roller 72 (transfer roller means 71) of the pressure transfer section 8, the take-up roller 12 of the photosensitive member collection section 9 and the feed roller means 101, respectively. The feed roller means 101 comprises, as in the first embodiment, the drive roller 106 to which the feed motor 105 is connected and the pressure roller 107, and constitutes the secondary drive means. The feed roller means 101 is disposed in the transport path 6 between the heat developing section 7 and the pressure transfer section 8, and they are controlled via the sensor means 109 disposed upstream from the exposure section 4, so that the transport speed of the photosensitive member F in the exposure section 4 is constant. The tension roller means 108 is disposed in the transport path 6 downstream from the feed roller means 101, and it sends the photosensitive member F to the pressure transfer section 8 in a tensioned condition while a buffer is formed in this part.

Fig. 7 shows the transport system for the photosensitive member F in a sixth embodiment. In this embodiment, as in the first embodiment, the transport system of the main unit 1 comprises the drive motors 102, 103 and 104 connected to the supply roller 22 of the supply section 5, the top roller 72 (transfer roller means 71) of the pressure transfer section 8 and the take-up roller 12 of the photosensitive member collection section 9, respectively. The transfer roller means 71 is controlled via the sensor means 109 disposed upstream from the exposure section 4 so that the transport speed of the photosensitive member F in the exposure section 4 is constant. In this case, transport upstream from the pressure transfer section 8 is performed by the transfer roller means 71 and, therefore, unlike the second to fifth embodiments, the feed roller means, etc., (secondary transport means) can be eliminated. Moreover, there is no slack in the photosensitive member F in any part of the transport path so the tension roller means 108 or the tension arm 111 can also be eliminated.

In these embodiments, the supply roller 22, top roller 72, take-up roller 12, feed roller means 101 and tension roller 108 may be configured such that they move between a contact position and a retracted position or are provided with a clutch which allows them to rotate freely when necessary so that their contact with or regulation of the photosensitive member F may be released as required when the photosensitive member F is initially set or rewound.

In some of the transport means of the above embodiments, the sensor means 109 is used to control the transport speed of the photosensitive member so that it stays constant in the exposure section 4. Further, in these embodiments, the sensor means 109 is disposed somewhere upstream from the exposure section 4. There is, however, no restriction to this location as long as the transport speed in the exposure section 4 can be detected. For instance, detection is possible downstream from the exposure section 4 and even in the exposure section. Below are explanations of one embodiment in which the sensor means 109 is disposed before or after the exposure section 4 and another one in which the sensor means 109 is disposed in the exposure section.

Fig. 8 shows an embodiment of a sensor means disposed before or after the exposure section. As shown in the Figure, the sensor means 109 in the form of a so called encoder, comprises a pair of upper and lower detection rollers 116 and 117 disposed such that the photosensitive member F is sandwiched therebetween, a slit plate 118 fixed to the rotational axis 116a of the detection roller 116, and a transmission type photo sensor 119 that faces the slit plate 118 and detects the slit pulses. The transport speed of the photosensitive member F is transmitted to the slit plate 118 via the freely rotating detection rollers 116 and 117 and is detected by the photo sensor 119 as the number of slits in the slit plate 118 passed by during a unit time. A controller 110 is connected to the photo sensor 119. The transport speed is calculated from the slit number per unit time by an operator part 110a of the controller 110, and a control part 110b outputs a control signal to a drive part 120 of the drive motor so that this value remains constant.

Instead of this encoder, it is also possible to detect the transport speed of the photosensitive F by means of a potentiometer.

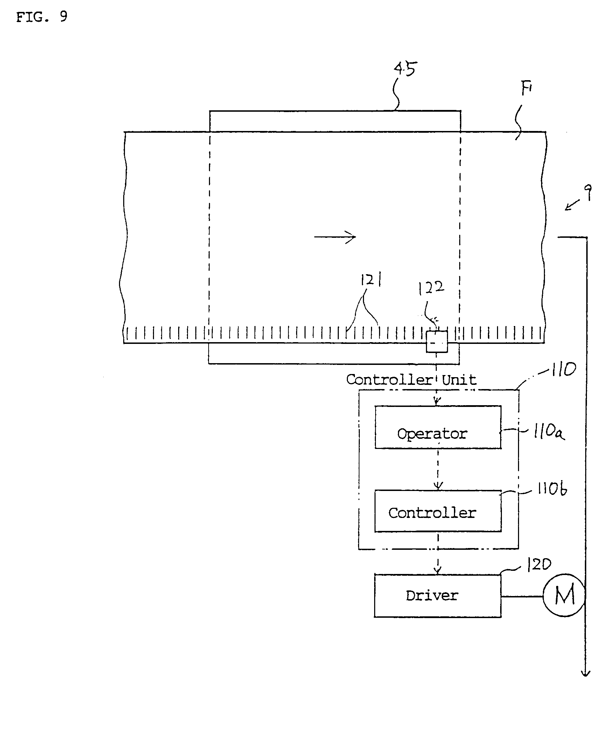

Fig. 9 shows an embodiment in which the sensor means is disposed in the exposure section. As shown in the Figure, this sensor means 109 requires a photosensitive member F on which markings have been previously formed on one side. These markings form a line pattern 121 with fixed intervals along the length of the photosensitive member F, i.e. the direction of transport. This line pattern is detected by a reflective type photo sensor 122. The photo sensor 122 is built into the exposure table 45 so that it faces the photosensitive member F from the side. In this case, as in the above embodiment, the controller 110 is connected to the photo sensor 122. The operator part 110a of the controller 110 calculates the transport speed from the number of lines passing per unit time, and the control part 110b outputs a control signal to the drive part 120 of the drive motor so that this value remains constant.

By means of the configurations of these embodiments, it becomes possible to (1) maintain the transport speed of the photosensitive member F constant in the exposure section 4, (2) prevent the transport speed downstream from the exposure section 4 from affecting the transport speed in the exposure section 4, and (3) absorb slack in the photosensitive member F, thus facilitating accurate, smooth transport of the photosensitive member F with a simple configuration.

The above embodiments were explained using a color copier. However, the invention is also applicable to printers, plotters, facsimile machines and electronic cameras.

## Claims

1. An image forming device in which a long photosensitive member (F) is sequentially transported from a supply section (5) along a transport path (6) to an exposure section (4), a heat developing section (7) and a pressure transfer section (8), a latent image is formed on the photosensitive member by exposure to an input image in the exposure section (4), the latent image is heat developed in the heat developing section (7) and the developed image is then transferred to a transfer member (P) in the pressure transfer section (8), wherein a main transport means (72, 76, 103) for transporting the photosensitive member along the transport path (6) is disposed in the pressure transfer section (8).

2. The device of claim 1 wherein a sensor means (109) that detects the transport speed of the photosensitive member (F) is disposed in the transport path (6) upstream from the heat developing section (7), and
   a controller (110) is employed that controls the transport speed of the main transport means based on the value detected by the sensor means.

3. The device of claim 1 wherein a secondary transport means (101) that transports the photosensitive member (F) at a slightly higher speed than does the main transport means (72, 76, 103) is disposed in the transport path (6) between the heat developing section (7) and the pressure transfer section (8);
   a sensor means (109) that detects the transport speed of the photosensitive member is disposed in the transport path upstream from the heat developing section (7); and
   a controller (110) is employed that controls the transport speed of the secondary transport means based on the value detected by the sensor means.

4. The device of claim 1 wherein a secondary transport means (52, 107, 115) that transports the photosensitive member at a slightly higher speed than does the main transport means (72, 76, 103) is disposed in the heat developing section;

a sensor means (109) that detects the transport speed of the photosensitive member (F) is disposed in the transport path (6) upstream from the heat developing section (7); and

a controller (110) is employed that controls the transport speed of the secondary transport means based on the value detected by the sensor means.

5. The device of claim 1 wherein a secondary transport means (101) that transports the photosensitive member (F) at a slightly higher speed than does the main transport means (72, 76, 103) is disposed in the transport path (6) between the exposure section (4) and the heat developing section (7).

6. The device of claim 1 wherein a secondary transport means (101) that transports the photosensitive member (F) at a slightly higher speed than does the main transport means (72, 76, 103) is disposed in the transport path (6) between the supply section (5) and the exposure section (4).

7. The device of claim 1 wherein a secondary transport means (22, 102) that transports the photosensitive member (F) at a slightly higher speed than does the main transport means (72, 76, 103) is disposed in the supply section (5);

a sensor means (109) that detects the transport speed of the photosensitive member is disposed in the transport path upstream from the heat developing section (7); and

a controller (110) is employed that controls the transport speed of the secondary transport means based on the value detected by the sensor means.

8. The device of claim 3 wherein a tensioning means (108) that applies tension to the photosensitive member (F) is disposed in the transport path downstream from the secondary transport means between the heat developing section (7) and the pressure transfer section (8).

9. The device of claim 5 wherein a tensioning means (108) that applies tension to the photosensitive member (F) is disposed in the transport path (6) downstream from the secondary transport means (101) between the exposure section (4) and the heat developing section (7).

10. The device of claim 6 or 7 wherein a tensioning means (108) that applies tension to the photosensitive member (F) is disposed in the transport path (6) between the heat developing section (7) and the pressure transfer section (8)

11. The device of any of claims 8 or 9 wherein the tensioning means (108) that applies tension to the photosensitive member comprises a tension roller (108a, 108b).

12. The device of any of claims 8 to 10 wherein the tensioning means (111) comprises a tension arm unit (112) that pushes against and applies tension to the photosensitive member (F) from nearly a perpendicular direction.

13. The device of claim 2, 3, 4 or 7 wherein the sensor means (109) comprises an idle roller (116, 117) that rotates when it comes into contact with the photosensitive member (F); and

an encoder (118) attached to the rotating shaft of the idle roller

14. The device of claim 2, 3, 4 or 7 wherein the sensor means (109) comprises a marking pattern (121) written in the lengthwise direction of the photosensitive member (F); and

a sensor (122) that detects the marking pattern.

FIG. 1

FIG. 2

FIG. 3

FIG. 4

FIG. 5

FIG. 6

FIG. 7

FIG. 8

Controller
Unit ---110

Operator    110a

Controller    110b

Driver    120

FIG. 9

Controller Unit

Operator ──110a

Controller ──110b

Driver ──120

## DOCUMENTS CONSIDERED TO BE RELEVANT

| Category | Citation of document with indication, where appropriate, of relevant passages | Relevant to claim | CLASSIFICATION OF THE APPLICATION (Int. Cl.5) |
|---|---|---|---|
| Y<br>A | EP-A-0 350 310 (BROTHER)<br>* column 1, line 7 - line 11 *<br>* column 5, line 35 - line 53 *<br>* column 7, line 16 - line 49 *<br>* column 8, line 37 - line 58; figures 1,4-6 *<br>--- | 1<br>8-11 | G03B27/32<br>G03F7/00 |
| Y<br>A | US-A-4 841 339 (TANIGUCHI)<br>* column 1, line 5 - line 14 *<br>* column 2, line 7 - line 61 *<br>* column 5, line 16 - line 33; figures 1-3 *<br>--- | 1<br>6 | |
| P,A | US-A-4 994 851 (IWAI)<br><br>* abstract *<br>* column 5, line 37 - line 51 *<br>* column 9, line 41 - column 10, line 9; figures 1,2 *<br>& JP-A-2 234 145 (SHARP)<br>--- | 2-4,7,<br>13,14 | |
| A | EP-A-0 326 080 (DAINIPPPON SCREEN)<br>* column 1, line 4 - line 12 *<br>* column 9, line 14 - line 23; figure 1 *<br>--- | 2-4,7 | TECHNICAL FIELDS SEARCHED (Int. Cl.5) |
| A | US-A-4 819 032 (NAGUMO)<br>* column 5, line 50 - line 63; claim 1; figure 1 *<br>--- | 12 | G03B<br>G03D<br>G03F |
| P,A | EP-A-0 434 032 (SHARP)<br>* abstract *<br>* column 7, line 42 - line 57; figures 1,2 *<br>----- | 3-7 | |

The present search report has been drawn up for all claims

| Place of search | Date of completion of the search | Examiner |
|---|---|---|
| THE HAGUE | 29 JUNE 1992 | GREISER N. |

EPO FORM 1503 03.82 (P0401)